# EUROPEAN PATENT APPLICATION

(11) **EP 3 151 289 A1**
(43) Date of publication of application: **05.04.2017**
(21) Application number: 16191774.5
(22) Date of filing: 30.09.2016
(51) Int. Cl.: H01L 31/074, H01L 31/0216, H01L 31/032

(54) **SOLAR CELL**

(30) Priority: 01.10.2015 KR 20150138657; 23.09.2016 KR 20160122173
(71) Applicant: LG Electronics Inc., Seoul 07336 (KR)
(72) Inventor: CHANG, Jaewon, 08592 Seoul (KR); KIM, Jinsung, 08592 Seoul (KR); YOON, Philwon, 08592 Seoul (KR); JUNG, Ilhyoung, 08592 Seoul (KR); LEE, Seunghun, 08592 Seoul (KR); SHIM, Seunghwan, 08592 Seoul (KR); KIM, Jinah, 08592 Seoul (KR)
(74) Representative: Katérle, Axel

(57) **Abstract**

Disclosed is a solar cell including a semiconductor substrate including a semiconductor material, a tunneling layer disposed over one surface of the semiconductor substrate, a first conductive area and a second conductive area disposed over the tunneling layer and having opposite conductive types, and an electrode including a first electrode electrically connected to the first conductive area and a second electrode electrically connected to the second conductive area. At least one of the first conductive area and the second conductive area is configured as a metal compound layer.

## Description

### CROSS-REFERENCE TO RELATED APPLICATIONS

This application claims the priority benefit of Korean Patent Application No. 10-2015-0138657, filed on October 1, 2015 and No 10-2016-0122173, filed on September 23, 2016 in the Korean Intellectual Property Office, the disclosures of which are incorporated herein by reference.

### BACKGROUND OF THE INVENTION

### Field of the Invention

The present inventive concept relates to a solar cell, and more particularly, to a solar cell including a metal oxide.

### Description of the Related Art

Recently, due to depletion of existing energy resources, such as oil and coal, interest in alternative sources of energy to replace the existing energy resources is increasing. Most of all, solar cells are popular next generation cells to convert sunlight into electrical energy.

Solar cells may be manufactured by forming various layers and electrodes based on some design. The efficiency of solar cells may be determined by the design of the various layers and electrodes. In order for solar cells to be commercialized, the problem of low efficiency and low productivity needs to be overcome, and thus, there is a demand for a solar cell capable of maximizing the efficiency and productivity thereof.

### SUMMARY OF THE INVENTION

Therefore, the present inventive concept has been made in view of the above problems, and it is an object of the present inventive concept to provide a solar cell having excellent efficiency and high productivity.

According to one aspect of the present inventive concept, the above and other objects can be accomplished by the provision of a solar cell including a semiconductor substrate including a semiconductor material, a tunneling layer disposed over one surface of the semiconductor substrate, a first conductive area and a second conductive area disposed over the tunneling layer and having opposite conductive types, and an electrode including a first electrode electrically connected to the first conductive area and a second electrode electrically connected to the second conductive area, wherein at least one of the first conductive area and the second conductive area is configured as a metal compound layer.

According to another aspect of the present inventive concept, there is provided a solar cell including a semiconductor substrate, a first conductive area formed on one surface of the semiconductor substrate, a second conductive area formed on another surface opposite the one surface of the semiconductor substrate, a first electrode connected to the first conductive area, and a second electrode connected to the second conductive area, wherein each of the first conductive area and the second conductive area is configured as a metal oxide layer.

### BRIEF DESCRIPTION OF THE DRAWINGS

The above and other objects, features and other advantages of the present inventive concept will be more clearly understood from the following detailed description taken in conjunction with the accompanying drawings, in which:
FIG. 1 is a sectional view of a solar cell according to an embodiment of the present inventive concept;
FIG. 2 is a partial rear plan view of the solar cell illustrated in FIG. 1;
FIG. 3 is a band diagram of a semiconductor substrate, a tunneling layer, and a first conductive area in the solar cell according to the embodiment of the present inventive concept;
FIG. 4 is a band diagram of the semiconductor substrate, the tunneling layer, and a second conductive area in the solar cell according to the embodiment of the present inventive concept;
FIG. 5 is a sectional view for explaining a solar cell according to an embodiment of the present inventive concept;
FIG. 6 is a plan view of the solar cell illustrated in FIG. 5;
FIG. 7 is a band diagram of a semiconductor substrate and a first conductive area in the solar cell illustrated in FIG. 6;
FIG. 8 is a band diagram of the semiconductor substrate and a second conductive area in the solar cell illustrated in FIG. 6;
FIG. 9 is a sectional view for explaining a solar cell according to an embodiment of the present inventive concept;
FIG. 10 is a sectional view for explaining a solar cell according to an embodiment of the present inventive concept;
FIG. 11 is a band diagram of a semiconductor substrate, a tunneling layer, and a first conductive area in the solar cell illustrated in FIG. 10;
FIG. 12 is a band diagram of the semiconductor substrate, the tunneling layer, and a second conductive area in the solar cell illustrated in FIG. 10;
FIG. 13 is a sectional view for explaining a solar cell according to an embodiment of the present inventive concept; and
FIG. 14 is a sectional view for explaining a solar cell according to an embodiment of the present inventive concept.

### DETAILED DESCRIPTION OF THE EMBODIMENTS

Reference will now be made in detail to the embodiments of the present inventive concept, examples of which are illustrated in the accompanying drawings. However, it will be understood that the present inventive concept should not be limited to the embodiments and may be modified in various ways.

In the drawings, to clearly and briefly explain the present inventive concept, illustration of elements having no connection with the description is omitted, and the same or extremely similar elements are designated by the same reference numerals throughout the specification. In addition, in the drawings, for more clear explanation, the dimensions of elements, such as thickness, width, and the like, are exaggerated or reduced, and thus the thickness, width, and the like of the present inventive concept are not limited to the illustration of the drawings.

In the entire specification, when an element is referred to as "including" another element, the element should not be understood as excluding other elements so long as there is no special conflicting description, and the element may include at least one other element. In addition, it will be understood that, when an element such as a layer, film, region or substrate is referred to as being "on" another element, it can be directly on the other element or intervening elements may also be present. On the other hand, when an element such as a layer, film, region or substrate is referred to as being "directly on" another element, this means that there are no intervening elements therebetween.

In addition, the terms "first", "second", etc. are simply used in order to distinguish elements from each other, and the present inventive concept is not limited thereto.

Hereinafter, a solar cell according to an embodiment of the present inventive concept will be described in detail with reference to the accompanying drawings.

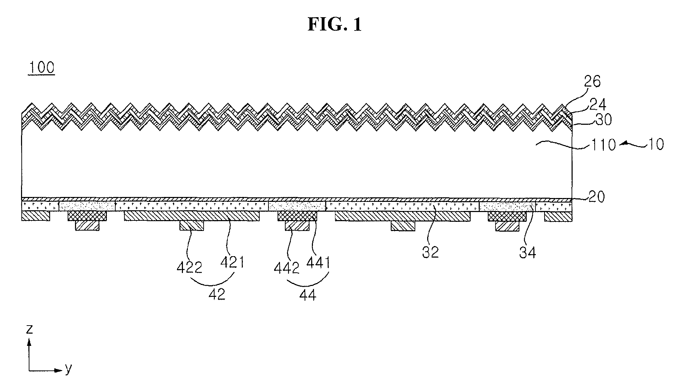

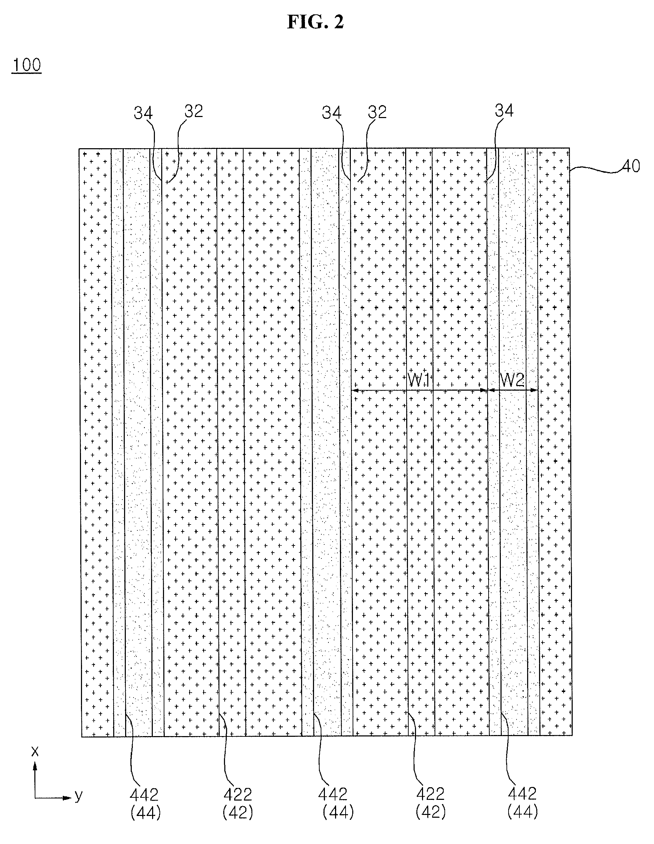

FIG. 1 is a sectional view of a solar cell according to an embodiment of the present inventive concept, and FIG. 2 is a partial rear plan view of the solar cell illustrated in FIG. 1. For simplified illustration, in FIG. 2, first electrode layers 421 and 441 of first and second electrodes 42 and 44 are not illustrated.

Referring to FIGS. 1 and 2, the solar cell 100 according to the present embodiment includes a semiconductor substrate 10 including a semiconductor material, a tunneling layer 20 formed over one surface (hereinafter referred to as "back surface") of the semiconductor substrate 10, a first conductive area 32 and a second conductive area 34 disposed over the tunneling layer 20, and a first electrode 42 and a second electrode 44 connected respectively to the first conductive area 32 and the second conductive area 34. At this time, in the present embodiment, at least one of the first conductive area 32 and the second conductive area 34 is configured as a metal compound layer (e.g. a metal oxide layer). The solar cell 100 may further include, for example, a front-surface field-forming layer 30, a transparent conductive film 24, and an anti-reflection film 26. This will be described below in more detail.

The semiconductor substrate 10 may include a base area 110, which includes an n-type or p-type dopant at a relatively low doping concentration, thus being of an n-type or p-type. The base area 110 may be formed of crystalline semiconductors including a second conductive dopant. In one example, the base area 110 may be formed of monocrystalline or polycrystalline semiconductors (e.g. monocrystalline or polycrystalline silicon) including a second conductive dopant. More particularly, the base area 110 may be formed of monocrystalline semiconductors including an n-type or p-type dopant (e.g. a monocrystalline semiconductor wafer, and more specifically, a semiconductor silicon wafer). The use of the base area 110 or the semiconductor substrate 10 having high crystallinity and thus low defects ensures excellent electrical properties.

In one example, when the base area 110 is of an n-type, a p-type first conductive area 32, which forms a junction with the base area 110 for forming carriers via photoelectric conversion (e.g. pn junction with the base area 110 with the tunneling layer 20 interposed therebetween), may be widely formed in order to increase a photoelectric conversion area. In addition, in this instance, the first conductive area 32 having a wide area may effectively collect holes, which move relatively slowly, thereby contributing to an increase in photoelectric conversion efficiency. In addition, when the base area 110 is of an n-type, a metal compound layer, which constitutes the first and second conductive areas 32 and 34, may be easily formed because it is formed of an affordable material. Specific constituent materials of the first and second conductive areas 32 and 34 will be described later in detail.

In the present embodiment, the other surface (hereinafter referred to as "front surface") of the semiconductor substrate 10 may be subjected to texturing so as to have protrusions, such as, for example, pyramids. The resulting texturing structure, i.e. the protrusions, formed on the semiconductor substrate 10, may have a given shape (e.g. a pyramidal shape) so as to have an outer surface formed along a particular crystalline face of semiconductors. When the protrusions are formed on, for example, the front surface of the semiconductor substrate 10 via texturing so as to increase the roughness of the surface, the reflectance of light introduced through the front surface of the semiconductor substrate 10 may be reduced. Accordingly, the quantity of light, which reaches the pn junction formed on the interface of the base area 110 and the first conductive area 32 may be increased, which may minimize shading loss.

In addition, the back surface of the semiconductor substrate 10 may be formed via, for example, mirror surface grinding, and thus may be a relatively smooth flat surface, which has a lower surface roughness than the front surface. In the instance where both the first and second conductive areas 32 and 34 are formed on the back surface of the semiconductor substrate 10 as in the present embodiment, the properties of the solar cell 100 may be greatly changed depending on the properties of the back surface of the semiconductor substrate 10. Therefore, the back surface of the semiconductor substrate 10 may have no protrusion formed via texturing in order to improve passivation, which may consequently improve the properties of the solar cell 100. However, the present inventive concept is not limited thereto. In some instances, the back surface of the semiconductor substrate 10 may be provided with protrusions via texturing. Various other alterations or modifications are possible and usable.

The tunneling layer 20 may be formed over the back surface of the semiconductor substrate 10. In one example, the tunneling layer 20 may come into contact with the back surface of the semiconductor substrate 10, thus achieving a simplified structure and improved tunneling effects. However, the present inventive concept is not limited thereto.

The tunneling layer 20 may serve as a barrier for electrons and holes, thereby preventing minority carriers from passing therethrough and allowing only majority carriers, which accumulate at a portion adjacent to the tunneling layer 20 and thus have a given amount of energy or more, to pass therethrough. At this time, the majority carriers, which have the given amount of energy or more, may easily pass through the tunneling layer 20 owing to tunneling effects. In addition, the tunneling layer 20 may serve as a diffusion barrier, which prevents the dopant of the conductive areas 32 and 34 from diffusing into the semiconductor substrate 10. The tunneling layer 20 may include various materials to enable the tunneling of the majority carriers. In one example, the tunneling layer 20 may include an oxide, nitride, semiconductor, or conductive polymer. For example, the tunneling layer 20 may include a silicon oxide, silicon nitride, silicon oxide nitride, intrinsic amorphous silicon, or intrinsic polycrystalline silicon. In particular, the tunneling layer 20 may be formed of a silicon oxide layer including a silicon oxide. This is because the silicon oxide layer has excellent passivation and thus ensures easy tunneling of carriers. The silicon oxide layer may be formed by thermal oxidation or chemical oxidation.

In order to achieve sufficient tunneling effects, the tunneling layer 20 may be thin. In one example, the thickness of the tunneling layer 20 may be 5 nm or less (more specifically, 2 nm or less, for example, within a range from 0.5 nm to 2 nm). When the thickness of the tunneling layer 20 exceeds 5 nm, smooth tunneling does not occur, and consequently, the solar cell 100 may not operate. When the thickness of the tunneling layer 20 is below 0.5 nm, it may be difficult to form the tunneling layer 20 having a desired quality. Accordingly, in order to further improve tunneling effects, the thickness of the tunneling layer 20 may be 2 nm or less (more specifically, within a range from 0.5 nm to 2 nm). However, the present inventive concept is not limited thereto, and the thickness of the tunneling layer 20 may have any of various values.

The tunneling layer 20 may be formed over the entire back surface of the semiconductor substrate 10. Thereby, the semiconductor substrate 10 may achieve improved passivation and may be formed via a simplified process without patterning.

The first and second conductive areas 32 and 34 may be disposed over the tunneling layer 20. The first and second conductive areas 32 and 34 may come into contact with the tunneling layer 20, thus having a simplified structure and maximizing tunneling effects. However, the present inventive concept is not limited thereto.

In the present embodiment, the first conductive area 32 and the second conductive area 34 are configured as metal compound layers formed of metal compounds, and do not include an n-type or p-type dopant. In one example, the first conductive area 32 and the second conductive area 34 may be metal oxide layers including metal oxides. When the first conductive area 32 and the second conductive area 34 are configured as metal oxide layers, easy manufacture, excellent chemical stability, and further improved passivation effects may be accomplished. On the other hand, when the first conductive area 32 or the second conductive area 34 is formed of, for example, a sulfide, chemical stability may be low.

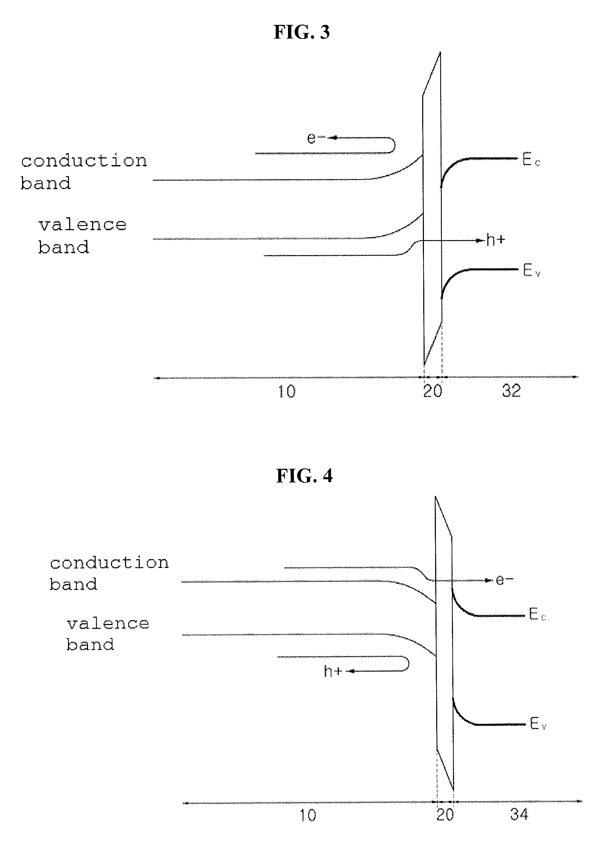

Specifically, the first conductive area 32 and the second conductive area 34 are formed of metal compounds, which are capable of selectively collecting electrons or holes in consideration of the energy band with relation to the semiconductor substrate 10 and the tunneling layer 20. Accordingly, the first conductive area 32 and the second conductive area 34 do not include a semiconductor material or a material that serves as a dopant in the corresponding semiconductor material. This will be described below in more detail with reference to FIGS. 3 and 4.

FIG. 3 is a band diagram illustrating the semiconductor substrate 10, the tunneling layer 20, and the first conductive area 32 in the solar cell 100 according to the embodiment of the present inventive concept. Also, FIG. 4 is a band diagram illustrating the semiconductor substrate 10, the tunneling layer 20, and the second conductive area 34 in the solar cell 100 according to the embodiment of the present inventive concept. At this time, the semiconductor substrate 10 will be described below as being of an n-type by way of example.

The metal compound layer of the first conductive area 32, which is capable of selectively collecting holes, may have a lower Fermi level than the Fermi level of the semiconductor substrate 10, and may have a greater work function than the work function of the semiconductor substrate 10. For example, the work function of the semiconductor substrate 10 may be approximately 3.7 eV, and the work function of the first conductive area 32 may be greater than 3.8 eV. More specifically, the work function of the first conductive area 32 may be 7 eV or less (for example, within a range from 3.8 eV to 7 eV). When the energy band gap described above is below 3.8 eV, the first conductive area 32 may have difficulty in selectively collecting only holes while excluding electrons.

When the first conductive area 32, which is configured as the metal compound layer having the Fermi level and work function described above, is bonded to the semiconductor substrate 10 with the tunneling layer 20 interposed therebetween, as illustrated in FIG. 3, the semiconductor substrate 10 and the first conductive area 32 are aligned with and bonded to each other so that they have the same Fermi level value. Through the bonding illustrated in FIG. 3, holes present in the valence band of the semiconductor substrate 10 may easily move to the valence band of the first conductive area 32 by passing through the tunneling layer 20. On the other hand, electrons in the semiconductor substrate 10 cannot pass through the tunneling layer 20.

In one example, the metal oxide layer, which may be used as the first conductive area 32 described above, may be selected from among, for example, a molybdenum oxide layer formed of a molybdenum oxide, a tungsten oxide layer formed of a tungsten oxide (e.g. WO₃), and a vanadium oxide layer formed of a vanadium oxide. In particular, when the first conductive area 32 includes a molybdenum oxide layer or a tungsten oxide layer, the first conductive area 32 may exhibit the excellent effect of selectively collecting holes.

The metal compound layer of the second conductive area 34, which is capable of selectively collecting electrons, may have a higher Fermi level than the Fermi level of the semiconductor substrate 10 and may have a smaller work function than the work function of the semiconductor substrate 10. For example, the work function of the semiconductor substrate 10 may be approximately 3.7 eV, and the work function of the second conductive area 34 may be within a range from 0.1 eV to 3.6 eV. More specifically, the energy band gap between the conduction band of the second conductive area 34 and the conduction band of the semiconductor substrate 10 may be 1 eV or less (for example, within a range from 0.1 eV to 1 eV). When the energy band gap described above exceeds 1 eV, the second conductive area 34 may have difficulty in selectively collecting electrons. When the energy band gap described above is below 0.1 eV, the second conductive area 34 may have difficulty in selectively collecting only electrons while excluding holes because of the small energy band gap.

When the second conductive area 34, which is configured as the metal compound layer having the Fermi level and work function described above, is bonded to the semiconductor substrate 10 with the tunneling layer 20 interposed therebetween, as illustrated in FIG. 4 by example, the semiconductor substrate 10 and the second conductive area 34 are aligned with and bonded to each other so that they have the same Fermi level value. Through the bonding illustrated in FIG. 4, electrons present in the conduction band of the semiconductor substrate 10 may easily move to the conduction band of the second conductive area 34 by passing through the tunneling layer 20. On the other hand, holes in the semiconductor substrate 10 cannot pass through the tunneling layer 20.

In one example, the metal oxide layer, which may be used as the second conductive area 34 described above, may be selected from among, for example, a titanium oxide layer formed of a titanium oxide (e.g. TiO₂), and a zinc oxide layer formed of a zinc oxide (e.g. ZnO). In particular, when the second conductive area 34 includes a titanium oxide layer, the second conductive area 34 may exhibit the excellent effect of selectively collecting electrons.

The first conductive area 32, which selectively collects holes and transmits the holes to the first electrode 42 as described above, serves as an emitter area. In addition, the second conductive area 34, which selectively collects electrons and transmits the electrons to the second electrode 44, serves as a back-surface field area.

At this time, the thickness of each of the first conductive area 32 and the second conductive area 34 may be within a range from 1 nm to 100 nm. The first conductive area 32 and the second conductive area 34 may increase in resistance when the thickness thereof is increased because they are metal compound layers that include no dopant. In consideration of this, the thickness of each of the first conductive area 32 and the second conductive area 34 may be set to 100 nm or less. When the thickness of the first conductive area 32 or the second conductive area 34 is below 1 nm, the first or second conductive area 32 or 34 may not sufficiently show the role thereof. However, the present inventive concept is not limited as to the thickness of the first and second conductive areas 32 and 34.

The first and second conductive areas 32 and 34 described above may be formed using various methods. In one example, the first and second conductive areas 32 and 34 may be formed using, for example, deposition or printing.

The first conductive area 32 and the second conductive area 34 do not cause, for example, short circuits, even if they are located so that side surfaces thereof come into contact with each other, because the first and second conductive areas 32 and 34 include no dopant. However, the present inventive concept is not limited thereto. Accordingly, in an alternative embodiment, a barrier area may be disposed over the tunneling layer 20 at a position between the first conductive area 32 and the second conductive area 34 so as to prevent the first and second conductive areas 32 and 34 from coming into contact with each other. The barrier area may take the form of an empty space, or may have any of various structures such as, for example, a structure including an intrinsic semiconductor layer or a compound, such as, an oxide, or another material.

When the first and second conductive areas 32 and 34 include no semiconductor material and no dopant, recombination caused by such a dopant may be minimized. In addition, the first and second conductive areas 32 and 34, which are formed of metal compounds (e.g. metal oxides), serve as a passivation layer, resulting in improved passivation effects. In addition, various processes such as, for example, deposition of a semiconductor layer formed of a semiconductor material, doping, and activation thermal treatment may be omitted, and in particular, high-temperature processes may be omitted. In this way, the productivity of the solar cell 100 may be improved, and the semiconductor substrate 10 may maintain excellent properties.

The above description and the drawings illustrate that both the first and second conductive areas 32 and 34 are configured as the metal compound layers including no dopant. However, the present inventive concept is not limited thereto, and only one of the first and second conductive areas 32 and 34 may be configured as a metal compound layer including no dopant. Various other alterations or modifications are possible and usable.

In this instance, the first conductive area 32, which collects different carriers (i.e. holes) from majority carriers of the base area 110, may be wider than the second conductive area 34, which collects the same carriers (i.e. electrons) as the majority carriers of the base area 110. As such, the first conductive area 32, which functions as an emitter area, may be sufficiently wide. In addition, the wide first conductive area 32 may effectively collect holes, which move relatively slowly. The plan structure of the first conductive area 32 and the second conductive area 34 will be described later in more detail with reference to FIG. 2.

The electrodes 42 and 44, which are disposed on the back surface of the semiconductor substrate 10, include the first electrode 42, which is electrically and physically connected to the first conductive area 32, and the second electrode 44, which is electrically and physically connected to the second conductive area 34.

At this time, the first electrode 42 may include a first electrode layer 421 and a second electrode layer 422, which are stacked over the first conductive area 32 in sequence.

In this instance, the first electrode layer 421 may be relatively widely formed over (for example, in contact with) the first conductive area 32. When the first electrode layer 421 is widely formed over the first conductive area 32, carriers may easily reach the second electrode layer 422 by passing through the first electrode layer 421, which may result in reduced resistance in the horizontal direction. In particular, in the present embodiment, because the first conductive area 32 is configured as the metal compound layer, which is not doped and includes no dopant, may increase in resistance, the first electrode layer 421 is provided in order to effectively reduce the resistance.

Because the first electrode layer 421 is formed into a wide area over the first conductive area 32, the first electrode layer 421 may be formed of a material capable of transmitting light (i.e. a light-transmitting material). That is, the first electrode layer 421 may be formed of a transparent conductive material in order to enable the transmission of light and the easy movement of carriers. As such, the first electrode layer 421 does not prevent the transmission of light even if it is formed into a wide area over the first conductive area 32.

In one example, the first electrode layer 421 may include an indium tin oxide (ITO) or a carbon nano tube (CNT). However, the present inventive concept is not limited thereto, and the first electrode layer 421 may include any of various other materials.

The second electrode layer 422 may be formed over the first electrode layer 421. In one example, the second electrode layer 422 may come into contact with the first electrode layer 421, which may simplify the configuration of the first electrode 42. However, the present inventive concept is not limited thereto, and various alterations or modifications are possible and usable. For example, an alteration, in which a separate layer is present between the first electrode layer 421 and the second electrode layer 422, is possible.

The second electrode layer 422, disposed over the first electrode layer 421, may be formed of a material having electrical conductivity superior to that of the first electrode layer 421. As such, the efficiency by which the second electrode layer 422 collects carriers and a reduction in the resistance of the second electrode layer 422 may be further improved. In one example, the second electrode layer 422 may be formed of a metal, which is opaque or has lower transparency than the first electrode layer 421 and has electrical conductivity superior to that of the first electrode layer 421.

As described above, because the second electrode layer 422 is opaque or has low transparency, and thus may prevent the entry of light, the second electrode layer 422 may have a given pattern so as to minimize shading loss. The second electrode layer 422 has a smaller area than the first electrode layer 421. Thereby, light may be introduced into a portion at which the second electrode layer 422 is not formed. The plan shape of the second electrode layer 422 will be described later in more detail with reference to FIG. 2.

The first and second electrode layers 421 and 422 of the first electrode 42 may be formed using various methods. In one example, the first and second electrode layers 421 and 422 may be formed using, for example, deposition, sputtering, or printing.

The second electrode 44 may include a first electrode layer 441 and a second electrode layer 442, which are stacked over the second conductive area 34 in sequence. The role, material, shape and the like of the first and second electrode layers 441 and 442 of the second electrode 44 may be the same as the role, material, shape and the like of the first and second electrode layers 421 and 422 of the first electrode 42 except for the fact that the second electrode 44 is located over the second conductive area 34, and therefore the description related to the first electrode 42 may be equally applied to the second electrode 44.

Insulation films, which include, for example, a back-surface passivation film, an anti-reflection film, and a reflection film, may be additionally formed over the first and second conductive areas 32 and 34 and/or the first electrode layers 421 and 441 on the back surface of the semiconductor substrate 10.

Hereinafter, one example of the plan shape of the first conductive area 32, the second conductive area 34, and the second electrode layers 422 and 442 of the first and second electrodes 42 and 44 will be described in detail with reference to FIGS. 1 and 2.

Referring to FIGS. 1 and 2, in the present embodiment, the first conductive area 32 and the second conductive area 34 are elongated to form stripes and are alternately arranged in the direction crossing the longitudinal direction thereof. A plurality of first conductive areas 32, which is spaced apart from one another, may be interconnected at one edge thereof, and a plurality of second conductive areas 34, which is spaced apart from one another, may be interconnected at an opposite edge thereof. However, the present inventive concept is not limited thereto.

At this time, the first conductive area 32 may be wider than the second conductive area 34. In one example, the areas of the first conductive area 32 and the second conductive area 34 may be adjusted by providing the first and second conductive areas 32 and 34 with different widths. That is, the width W1 of the first conductive area 32 may be greater than the width W2 of the second conductive area 34.

In addition, the second electrode layer 422 of the first electrode 42 may take the form of stripes so as to correspond to the first conductive areas 32, and the second electrode layer 442 of the second electrode 44 may take the form of stripes so as to correspond to the second conductive areas 34. For simplified illustration, the first electrode layer 421 of the first electrode 42 may be wider than the second electrode layer 422 and may take the form of stripes, and the first electrode layer 441 of the second electrode 44 may be wider than the second electrode layer 442 and may take the form of stripes. In addition, in FIGS. 1 and 2, the striped portions of the first electrode 42 may be interconnected at one edge thereof, and the striped portions of the second electrode 44 may be interconnected at an opposite edge thereof. However, the present inventive concept is not limited thereto.

Referring again to FIG. 1, the front-surface field-forming layer 30 may be disposed over the front surface of the semiconductor substrate 10. In one example, the front-surface field-forming layer 30 may be formed in contact with the front surface of the semiconductor substrate 10 so as to simplify the overall structure and to maximize the effect of forming a field area. However, the present inventive concept is not limited thereto.

The front-surface field-forming layer 30 may be configured as a film having a fixed charge, or the metal compound layer, which is capable of selectively collecting electrons or holes as described above. For example, the front-surface field-forming layer 30 may be an aluminum oxide layer including an aluminum oxide having a fixed charge. Alternatively, the front-surface field-forming layer 30 may be configured as a molybdenum oxide layer, a tungsten oxide layer, a vanadium oxide layer, a titanium oxide layer, or a zinc oxide layer, which may selectively collect electrons or holes. Alternatively, the front-surface field-forming layer 30 may be the combination of a plurality of layers described above.

At this time, the front-surface field-forming layer 30 may be formed of the same layer as one of the metal compound layer, which constitutes the first or second conductive area 32 or 34, which may simplify the manufacturing process. In one example, the front-surface field-forming layer 30 and the second conductive area 34 may be configured as a titanium oxide layer.

The front-surface field-forming layer 30 described above may have a fixed charge and may not be connected to the electrodes 42 and 44, which are connected to an external circuit or another solar cell 100, or may have a field area, which selectively collects electrons or holes so as to prevent the electrons and holes from being recombined with each other near the front surface of the semiconductor substrate 10. In this instance, because the semiconductor substrate 10 includes only the base area 110 without a separate doped area, defects of the semiconductor substrate 10 may be minimized.

In addition, the front-surface field-forming layer 30 may be formed of a compound (e.g. an oxide), thereby enabling the effective passivation of the front surface of the semiconductor substrate 10.

At this time, the thickness of the front-surface field-forming layer 30 may be equal to or less than the thickness of the first or second conductive area 32 or 34. This is because the front-surface field-forming layer 30 does not serve to transfer carriers to the outside, and thus may have a relatively small thickness. In one example, the thickness of the front-surface field-forming layer 30 may be within a range from 1 nm to 10 nm. With this thickness, the front-surface field-forming layer 30 may exert sufficient effects thereof. However, the present inventive concept is not limited as to the thickness of the front-surface field-forming layer 30.

In an alternative embodiment, rather than forming the front-surface field-forming layer 30, the front surface of the semiconductor substrate 10 may be doped with a dopant, which is of the same conductive type as the base area 110, at a high concentration, so as to form a doping area. The doping area may be used as a field area.

The transparent conductive film 24 may be disposed over (for example, in contact with) the front surface of the semiconductor substrate 10 or the front-surface field-forming layer 30. The transparent conductive film 24 is a floating electrode, which is not connected to an external circuit or another solar cell 100. The floating electrode may prevent, for example, unnecessary ions from being collected on the surface of the semiconductor substrate 10. This may prevent degradation caused by, for example, ions (i.e. Potentially Induced Degradation (PID) in which the efficiency by which a solar cell module generates electricity is reduced in high-temperature and high-humidity environments).

In one example, the transparent conductive film 24 may include an indium tin oxide (ITO) or a carbon nano tube (CNT). However, the present inventive concept is not limited thereto, and the transparent conductive film 24 may include any of various other materials.

The transparent conductive film 24 may not be necessary, and may be not provided.

The anti-reflection film 26 may be disposed over (for example, in contact with) the front surface of the semiconductor substrate 10 or the transparent conductive film 24.

The anti-reflection film 26 serves to reduce the reflectance of light introduced into the front surface of the semiconductor substrate 10. This may increase the quantity of light, which reaches the pn junction formed at the interface between the base area 110 and the first conductive area 32. Thereby, the short circuit current Isc of the solar cell 100 may be increased.

The anti-reflection film 26 may be formed of various materials. In one example, the anti-reflection film 26 may be a single film or multiple films having the form of a combination of two or more films selected from among the group of a silicon nitride film, a silicon nitride film containing hydrogen, a silicon oxide film, a silicon oxide nitride film, an aluminum oxide film, a silicon carbide film, MgF₂, ZnS, TiO₂ and CeO₂ films. In one example, the anti-reflection film 26 may be a silicon nitride film.

The front-surface field-forming layer 30, the transparent conductive film 24, and the anti-reflection film 26 may be formed substantially throughout the front surface of the semiconductor substrate 10. In this instance, the expression "formed throughout the front surface" includes the meaning of being physically completely formed over the entire front surface as well as the meaning of being formed so as to inevitably exclude a portion thereof. In this way, the manufacturing process may be simplified and each layer may sufficiently exert the role thereof.

When light is introduced into the solar cell 100 according to the present embodiment, electrons and holes are produced via photoelectric conversion, and the produced electrons and holes move to the first conductive area 32 and the second conductive area 34 through the tunneling layer 20, and thereafter are transmitted to the first and second electrodes 42 and 44. The electrons and holes transmitted to the first and second electrodes 42 and 44 move to an external circuit or another solar cell 100. Thereby, electricity is generated.

In the solar cell 100 having a back-surface electrode structure in which the electrodes 42 and 44 are formed on the back surface of the semiconductor substrate 10 and no electrode is formed on the front surface of the semiconductor substrate 10, shading loss may be minimized on the front surface of the semiconductor substrate 10. Thereby, the efficiency of the solar cell 100 may be improved. However, the present inventive concept is not limited thereto. In particular, because at least one of the first and second conductive areas 32 and 34 is configured as the metal compound layer in the present embodiment, the second electrode layers 422 and 442 of the electrodes 42 and 44 may be widely formed in order to compensate for low resistance. In this instance, the back-surface electrode structure may prevent problems attributable to shading loss.

In addition, because the first and second conductive areas 32 and 34 are formed over the semiconductor substrate 10 with the tunneling layer 20 interposed therebetween, the first and second conductive areas 32 and 34 are configured as layers separate from the semiconductor substrate 10. Thereby, recombination loss may be minimized compared to the instance where a doping area, which is formed by doping the semiconductor substrate 10 with a dopant, is used as a conductive area.

At this time, because the first and second conductive areas 32 and 34 include no semiconductor material and no dopant, problems caused by recombination may be minimized and passivation effects may be improved. In addition, the process of manufacturing the first and second conductive areas 32 and 34 may be simplified. Thereby, the efficiency and productivity of the solar cell 100 may be improved.

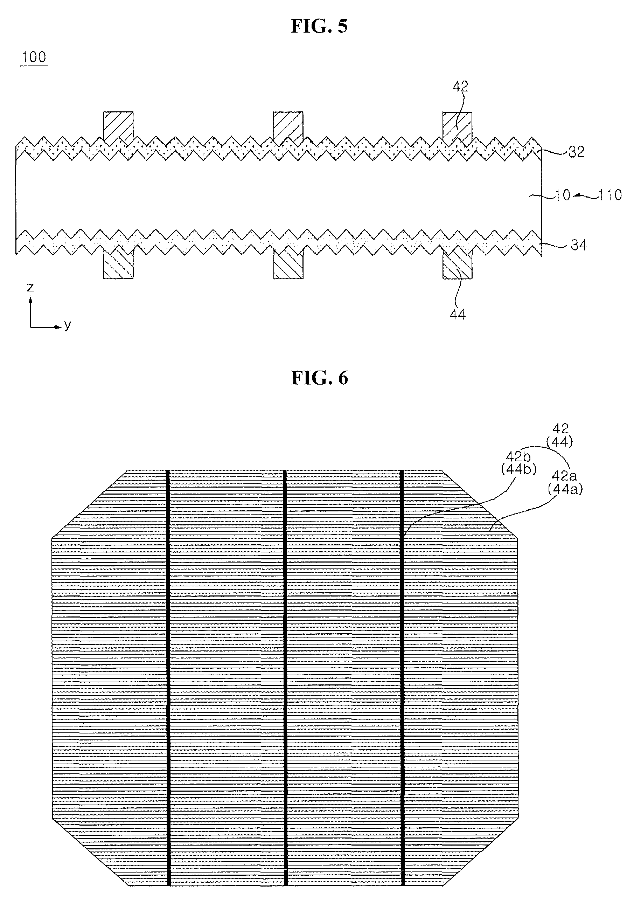

FIG. 5 is a sectional view for explaining a solar cell according to an embodiment of the present inventive concept, and FIG. 6 is a plan view of the solar cell illustrated in FIG. 5. In FIG. 6, a semiconductor substrate and electrodes are illustrated.

The solar cell according to the present embodiment may be substantially the same as the solar cell described with reference to FIG. 1 except that it is a double-sided solar cell. Thus, the same reference numerals designate the same elements, and a repeated or redundant description may be omitted.

Referring to FIG. 5, the solar cell 100 according to the present embodiment includes the semiconductor substrate 10, the first conductive area 32, which is disposed on one surface of the semiconductor substrate 10 and is of a first conductive type, the second conductive area 34, which is disposed over the other surface of the semiconductor substrate 10 and is of a second conductive type, and the first and second electrodes 42 and 44 connected respectively to the first and second conductive areas 32 and 34. At this time, each of the first and second conductive areas 32 and 34 may be formed of a metal compound, for example, a metal oxide. More specifically, each of the first and second conductive areas 32 and 34 may be configured as a binary metal oxide layer.

In the present embodiment, the front surface and/or the back surface of the semiconductor substrate 10 may be subjected to texturing so as to have protrusions. The resulting texturing structure, i.e. the protrusions, formed on the semiconductor substrate 10, may have a given shape (e.g. a pyramidal shape) so as to have an outer surface formed along a particular crystalline face of semiconductors. When the protrusions are formed on the front surface and/or the back surface of the semiconductor substrate 10 via texturing so as to increase the surface roughness, the reflectance of light introduced through the front surface and/or back surface of the semiconductor substrate 10 may be reduced. Accordingly, the quantity of light, which reaches the pn junction formed on the interface of the base area 110 and the first conductive area 32 or the second conductive area 34 may be increased, which may minimize shading loss.

However, the present inventive concept is not limited thereto. In some instances, the back surface of the semiconductor substrate 10 may be formed via, for example, mirror surface grinding, and thus may be a relatively smooth flat surface, which has a lower surface roughness than the front surface.

The first conductive area 32 may be disposed on one surface of the semiconductor substrate 10, and the second conductive area 34 may be disposed on the other surface.

In the present embodiment, the first conductive area 32 and the second conductive area 34 are configured as metal compound layers formed of metal compounds, and do not include an n-type or p-type dopant. In one example, the first conductive area 32 and the second conductive area 34 may be metal oxide layers including metal oxides. When the first conductive area 32 and the second conductive area 34 are configured as metal oxide layers, easy manufacture, excellent chemical stability, and further improved passivation effects may be accomplished. On the other hand, when the first conductive area 32 or the second conductive area 34 is formed of, for example, a sulfide, chemical stability may be low.

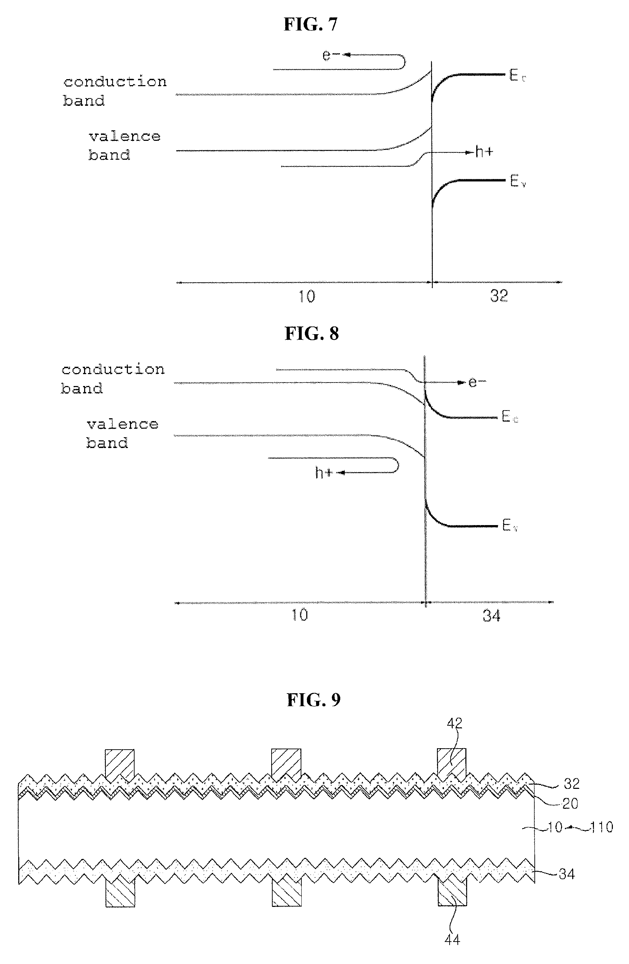

Specifically, the first conductive area 32 and the second conductive area 34 are formed of metal compounds, which are capable of selectively collecting electrons or holes in consideration of the energy band with relation to the semiconductor substrate 10. Accordingly, the first conductive area 32 and the second conductive area 34 do not include a semiconductor material or a material that serves as a dopant in the corresponding semiconductor material. This will be described below in more detail with reference to FIGS. 7 and 8.

FIG. 7 is a band diagram of the semiconductor substrate 10 and the first conductive area 32 in the solar cell 100 according to the embodiment of the present inventive concept, and FIG. 8 is a band diagram of the semiconductor substrate 10 and the second conductive area 34 in the solar cell 100 according to the embodiment of the present inventive concept. At this time, the instance where the semiconductor substrate 10 is of an n-type will be described by way of example.

The metal compound layer of the first conductive area 32, which is capable of selectively collecting holes, may have a lower Fermi level than the Fermi level of the semiconductor substrate 10, and may have a greater work function than the work function of the semiconductor substrate 10. For example, the work function of the semiconductor substrate 10 may be approximately 3.7 eV, and the work function of the first conductive area 32 may be greater than 3.8 eV. More specifically, the work function of the first conductive area 32 may be 7 eV or less (for example, within a range from 3.8 eV to 7 eV). When the energy band gap described above is below 3.8 eV, the first conductive area 32 may have difficulty in selectively collecting only holes while excluding electrons.

When the first conductive area 32, which is configured as the metal compound layer having the Fermi level and work function described above, is bonded to the semiconductor substrate 10 with the tunneling layer 20 interposed therebetween, as illustrated in FIG. 3, the semiconductor substrate 10 and the first conductive area 32 are aligned with and bonded to each other so that they have the same Fermi level value. When the first conductive area 32 is bonded to the semiconductor substrate 10 as illustrated in FIG. 7, holes present in the valence band of the semiconductor substrate 10 may easily move to the valence band of the first conductive area 32. On the other hand, electrons in the semiconductor substrate 10 may easily move to the valence band of the first conductive area 32.

In one example, the metal oxide layer, which may be used as the first conductive area 32 described above, may be at least one of a molybdenum oxide layer formed of a molybdenum oxide, a tungsten oxide layer formed of a tungsten oxide (e.g. WO₃), a vanadium oxide layer formed of a vanadium oxide (e.g. V₂Ox), a titanium oxide layer formed of a titanium oxide (e.g. TiO₂), a nickel oxide layer formed of a nickel oxide (e.g. NiO), a copper oxide layer formed of a copper oxide (CuO), a rhenium oxide layer formed of a rhenium oxide (e.g. ReO₃), a tantalum oxide layer formed of a tantalum oxide (e.g. TaOx), and a hafnium oxide layer formed of a hafnium oxide (e.g. HfO₂).

In particular, when the first conductive area 32 includes a molybdenum oxide layer or a tungsten oxide layer, the first conductive area 32 may exhibit the excellent effect of selectively collecting holes.

The metal compound layer of the second conductive area 34, which is capable of selectively collecting electrons, may have a higher Fermi level than the Fermi level of the semiconductor substrate 10 and may have a smaller work function than the work function of the semiconductor substrate 10. For example, the work function of the semiconductor substrate 10 may be approximately 3.7 eV, and the work function of the second conductive area 34 may be within a range from 0.1 eV to 3.6 eV. More specifically, the energy band gap between the conduction band of the second conductive area 34 and the conduction band of the semiconductor substrate 10 may be 1 eV or less (for example, within a range from 0.1 eV to 1 eV). When the energy band gap described above exceeds 1 eV, the second conductive area 34 may have difficulty in selectively collecting electrons. When the energy band gap described above is below 0.1 eV, the second conductive area 34 may have difficulty in selectively collecting only electrons while excluding holes because of the small energy band gap.

When the second conductive area 34, which is configured as the metal compound layer having the Fermi level and work function described above, is bonded to the semiconductor substrate 10, as illustrated in FIG. 8 by example, the semiconductor substrate 10 and the second conductive area 34 are aligned with and bonded to each other so that they have the same Fermi level value. Through the bonding illustrated in FIG. 8, electrons present in the conduction band of the semiconductor substrate 10 may easily move to the conduction band of the second conductive area 34 by passing through the tunneling layer 20. On the other hand, holes in the semiconductor substrate 10 cannot pass through the tunneling layer 20.

In one example, the metal oxide layer, which may be used as the second conductive area 34 described above, may be formed of at least one of a titanium oxide layer formed of a titanium oxide (e.g. TiO₂), a zinc oxide layer formed of a zinc oxide (e.g. ZnO), a tin oxide layer formed of a tin oxide (e.g. SnO₂), and a zirconium oxide layer formed of a zirconium oxide (e.g. ZrO).

In particular, when the second conductive area 34 includes a titanium oxide layer, the second conductive area 34 may exhibit the excellent effect of selectively collecting electrons.

The first conductive area 32, which selectively collects holes and transmits the holes to the first electrode 42 as described above, serves as an emitter area. In addition, the second conductive area 34, which selectively collects electrons and transmits the electrons to the second electrode 44, serves as a back-surface field area.

At this time, the thickness of each of the first conductive area 32 and the second conductive area 34 may be within a range from 1 nm to 100 nm. The first conductive area 32 and the second conductive area 34 may increase in resistance when the thickness thereof is increased because they are metal compound layers that include no dopant. In consideration of this, the thickness of each of the first conductive area 32 and the second conductive area 34 may be set to 100 nm or less. When the thickness of the first conductive area 32 or the second conductive area 34 is below 1 nm, the first or second conductive area 32 or 34 may not sufficiently show the role thereof. However, the present inventive concept is not limited as to the thickness of the first and second conductive areas 32 and 34.

The first and second conductive areas 32 and 34 described above may be formed using various methods. In one example, the first and second conductive areas 32 and 34 may be formed using, for example, deposition or printing.

When the first and second conductive areas 32 and 34 include no semiconductor material and no dopant, recombination caused by such a dopant may be minimized. In addition, the first and second conductive areas 32 and 34, which are formed of metal compounds (e.g. metal oxides), serve as a passivation layer, resulting in improved passivation effects. In addition, various processes such as, for example, deposition of a semiconductor layer formed of a semiconductor material, doping, and activation thermal treatment may be omitted, and in particular, high-temperature processes may be omitted. In this way, the productivity of the solar cell 100 may be improved, and the semiconductor substrate 10 may maintain excellent properties.

The above description and the drawings illustrate that both the first and second conductive areas 32 and 34 are configured as the metal compound layers including no dopant. However, the present inventive concept is not limited thereto, and only one of the first and second conductive areas 32 and 34 may be configured as a metal compound layer including no dopant. Various other alterations or modifications are possible and usable.

The electrodes 42 and 44 disposed on the front surface and the back surface of the semiconductor substrate 10 include the first electrode 42, which is electrically and physically connected to the first conductive area 32, and the second electrode 44, which is electrically and physically connected to the second conductive area 34.

Insulation films, which include, for example, a back-surface passivation film, an anti-reflection film, and a reflection film, may be additionally formed over the first and second conductive areas 32 and 34.

In the present inventive concept, the first and second conductive areas 32 and 34 may be formed separately from the semiconductor substrate 10. In the present inventive concept, the first and second conductive areas 32 and 34 are formed on the semiconductor substrate 10 via deposition, which may minimize damage to the semiconductor substrate 10. Thus, defects of the semiconductor substrate 10 may be minimized, which may improve the efficiency of the solar cell 100.

The plan shape of the first and second electrodes 42 and 44 will be described below in detail with reference to FIG. 6.

Referring to FIG. 6, the first and second electrodes 42 and 44 may include a plurality of finger electrodes 42a and 44a spaced apart from one another at a constant pitch. While FIG. 6 illustrates that the finger electrodes 42a and 44a are parallel to one another and are parallel to the edge of the semiconductor substrate 10, the present inventive concept is not limited thereto. In addition, the first and second electrodes 42 and 44 may include bus-bar electrodes 42b and 44b, which are formed in a direction crossing the finger electrodes 42a and 44a so as to interconnect the finger electrodes 42a and 44a. Only one bus-bar electrode 42b or 44b may be provided, or a plurality of bus-bar electrodes 42b or 44b may be arranged at a larger pitch than the pitch of the finger electrodes 42a and 44a as illustrated in FIG. 6. At this time, although the width of the bus-bar electrodes 42b and 44b may be larger than the width of the finger electrodes 42a and 44a, the present inventive concept is not limited thereto. Accordingly, the width of the bus-bar electrodes 42b and 44b may be equal to or less than the width of the finger electrodes 42a and 44a.

When viewing the cross section, both the finger electrode 42a and the bus-bar electrode 42b of the first electrode 42 may be formed so as to penetrate a passivation film and an anti-reflection film. That is, an opening may be formed so as to correspond to each of the finger electrode 42a and the bus-bar electrode 42b of the first electrode 42. In addition, both the finger electrode 44a and the bus-bar electrode 44b of the second electrode 44 may be formed so as to penetrate an anti-reflection film. That is, an opening may be formed so as to correspond to each of the finger electrode 44a and the bus-bar electrode 44b of the second electrode 44. However, the present inventive concept is not limited thereto. In another example, the finger electrode 42a of the first electrode 42 may be formed so as to penetrate an anti-reflection film, and the bus-bar electrode 42b may be formed over the anti-reflection film. In this instance, the opening may have a shape corresponding to the finger electrode 42a, and may not be formed in a portion at which only the bus-bar electrode 42b is located. In addition, the finger electrode 44a of the second electrode 44 may be formed so as to penetrate an anti-reflection film, and the bus-bar electrode 44b may be formed over the anti-reflection film. In this instance, the opening 104 may have a shape corresponding to the finger electrode 44a and may not be formed in a portion at which only the bus-bar electrode 44b is located.

FIG. 6 illustrates that the first electrode 42 and the second electrode 44 have the same plan shape. However, the present inventive concept is not limited thereto, and, for example, the width and pitch of the finger electrode 42a and the bus bar electrode 42b of the first electrode 42 may be different from the width and pitch of the finger electrode 44a and the bus bar electrode 44b of the second electrode 44. In addition, the first electrode 42 and the second electrode 44 may have different plan shapes, and various other alterative embodiments are possible.

In the present embodiment, as described above, the first and second electrodes 42 and 44 of the solar cell 100 have a given pattern so that the solar cell 100 has a bi-facial structure to allow light to be introduced into the front surface and the back surface of the semiconductor substrate 10. As such, the quantity of light for use in the solar cell 100 may be increased, which may contribute to improvement in the efficiency of the solar cell 100. However, the present inventive concept is not limited thereto, and the second electrode 44 may be formed throughout the back surface of the semiconductor substrate 10. Various other alternative embodiments are possible.

Hereinafter, the solar cell according to other embodiments of the present inventive concept will be described in detail with reference to FIGS. 9 to 16. A detailed description of the same or similar parts to those of the above-described embodiment will be omitted and only different parts will be described below in detail. In addition, the above-described embodiment and alternative embodiments thereof and the following embodiments and alternative embodiments thereof may be combined with one another, and this combination falls within the scope of the present inventive concept.

FIG. 9 is a sectional view of the solar cell according to an embodiment of the present inventive concept.

Referring to FIG. 9, in the present embodiment, the tunneling layer 20 is located between the semiconductor substrate 10 and the first conductive area 32.

The first conductive area 32, which is of a first conductive type, may be disposed over the tunneling layer 20 on one surface (e.g. the front surface) of the semiconductor substrate 10. The first conductive area 32 configures an emitter area, which forms a pn junction (or a pn tunnel junction) with the base area 110 with the tunneling layer 20 interposed therebetween so as to produce carriers via photo-electric conversion.

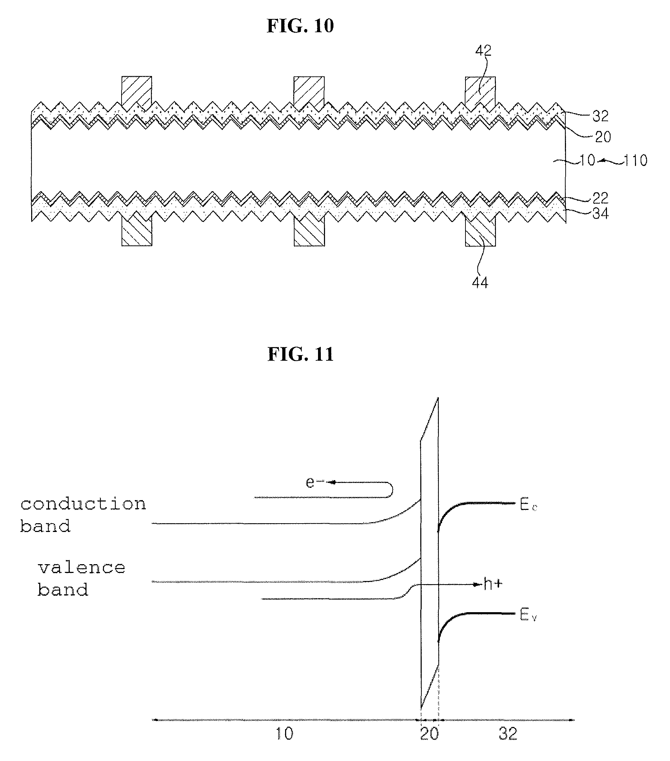

FIG. 10 is a sectional view of the solar cell according to the embodiment of the present inventive concept.

Referring to FIG. 10, in the present embodiment, another tunneling layer 22 is located between the semiconductor substrate 10 and the second conductive area 34. The above description related to the tunneling layer 20 may be directly applied to the tunneling layer 22 located between the semiconductor substrate 10 and the second conductive area 34, and thus a description related to the tunneling layer 22 will be omitted.

In the present embodiment, when the additional tunneling layer 22 is located between the semiconductor substrate 10 and the second conductive area 34, passivation effects may be maximized and smooth movement of carriers may be implemented. In the present embodiment, unlike the above embodiment described with reference to FIG. 5, the tunneling layers 20 and 22 are located between the semiconductor substrate 10 and the first conductive area 32 and between the semiconductor substrate 10 and the second conductive area 34.

In this instance, the energy band between the semiconductor substrate 10, the first and second conductive areas 32 and 34, and the tunneling layers 20 and 22 will be understood with reference to the band diagrams of FIGS. 7 and 8. The band diagrams of FIGS. 7 and 8 may be substantially the same as the band diagrams of FIGS. 3 and 4. Thus, a repeated or redundant description thereof will be omitted.

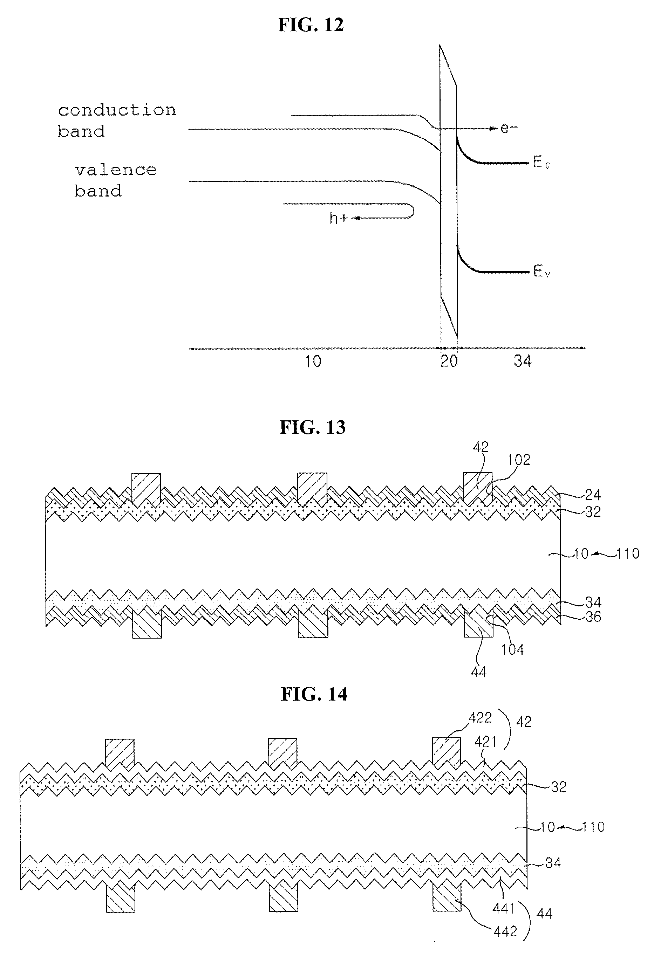

FIG. 13 is a sectional view for explaining a solar cell according to an embodiment of the present inventive concept.

Referring to FIG. 13, in the present embodiment, anti-reflection films 24 and 36 are disposed on the first conductive area 32 and the second conductive area 34.

The anti-reflection film 24 may be formed substantially throughout the front surface of the semiconductor substrate 10 over the first conductive area 32, excluding an opening 102 that corresponds to the first electrode 42. The anti-reflection film 24 reduces reflectance of light introduced into the front surface of the semiconductor substrate 10. When the reflectance of light introduced into the front surface of the semiconductor substrate 10 is reduced, the quantity of light, which reaches a pn junction formed on the interface of the base area 110 and the first conductive area 32 may be increased. Thereby, the short-circuit current of the solar cell may be increased.

The anti-reflection film 36 may be formed substantially throughout the back surface of the semiconductor substrate 10 over the second conductive area 34, excluding an opening 104 that corresponds to the second electrode 44. In one example, the anti-reflection film 36 may be formed in contact with the second conductive area 34. The anti-reflection film 36 reduces the reflectance of light introduced into the back surface of the semiconductor substrate 10. When the reflectance of light introduced into the back surface of the semiconductor substrate 10 is reduced, the quantity of light, which reaches a pn junction formed on the interface of the base area 110 and the second conductive area 34 may be increased. Thereby, the short-circuit current Isc of the solar cell may be increased.

The anti-reflection films 24 and 36 may be formed of various materials. In one example, the anti-reflection films 24 and 36 may be a single film or multiple films having the form of a combination of two or more films selected from among the group of a silicon nitride film, a silicon nitride film containing hydrogen, a silicon oxide film, a silicon oxide nitride film, an aluminum oxide film, MgF₂, ZnS, TiO₂ and CeO₂ films. In one example, the anti-reflection film 24 may be a silicon nitride film.

However, the present inventive concept is not limited thereto, and the anti-reflection films 24 and 36 may of course include various materials. In addition, instead of the anti-reflection film 24, a passivation film may be used, or a passivation film may be located between the first conductive area 32 and the anti-reflection film 24 and/or between the second conductive area 34 and the anti-reflection film 36. Alternatively, various other films, rather than the passivation film and the anti-reflection films 24 and 36, may be formed over the first and second conductive areas 32 and 34. Various other alterations or modifications are possible and useable.

FIG. 14 is a sectional view for explaining a solar cell according to the embodiment of the present inventive concept.

Referring to FIG. 14, the first electrode 42 may include the first electrode layer 421 and the second electrode layer 422, which are stacked over the first conductive area 32 in sequence.

In this instance, the first electrode layer 421 may be formed throughout (e.g. in contact with) the first conductive area 32. When the first electrode layer 421 is widely formed over the first conductive area 32, carriers may easily reach the second electrode layer 422 by passing through the first electrode layer 421, which may result in reduced resistance in the horizontal direction. In particular, in the present embodiment, because the first conductive area 32 is configured as the metal compound layer, which is not doped and includes no dopant, may increase in resistance, the first electrode layer 421 is provided in order to effectively reduce the resistance.

Because the first electrode layer 421 is formed throughout the first conductive area 32, the first electrode layer 421 may be formed of a material capable of transmitting light (i.e. a light-transmitting material). That is, the first electrode layer 421 may be formed of a transparent conductive material in order to enable the transmission of light and the easy movement of carriers. As such, the first electrode layer 421 does not prevent the transmission of light even if it is formed over the first conductive area 32.

For example, the first electrode layer 421 may include at least one of indium-tin oxide (indium tin oxide, ITO), aluminum zinc oxide (aluminum zinc oxide, AZO), a boron-zinc oxide (boron zinc oxide, BZO), indium tungsten oxide (indium tungsten oxide, IWO) and indium-cesium oxide (indium cesium oxide, ICO). However, the present inventive concept is not limited thereto.

Meanwhile, the first electrode layer 421 may include hydrogen and the above-described material as a major material. That is, the first electrode layer 421 may include indium-tin oxide containing hydrogen (ITO: H), aluminum zinc oxide containing hydrogen (AZO: H), a boron-zinc oxide containing hydrogen (BZO: H), indium tungsten oxide containing hydrogen (IWO: H) and indium-cesium oxide containing hydrogen (ICO: H).

The first electrode layer 421 may be formed by deposition. During the deposition, when implanted with hydrogen gas, the hydrogen may be contained in the first electrode layer 421. When the first electrode layer 421 including hydrogen, the first electrode layer 421 may improve the electron or hole mobility can be improved, and The transmission rate can be improved in the first electrode layer 421.

The first electrode layer 421 may include a different metal oxide from the first conductive area 32. In addition, the first electrode layer 421 may be formed of a metal oxide, which has a different work function from the first conductive area 32, without being limited thereto. The first electrode layer 421 may have substantially the same work function as the first conductive area 32.

The first electrode layer 421 may have electrical conductivity superior to that of the first conductive area 32. Thereby, the efficiency by which the first electrode layer 421 collects carriers and a reduction in the resistance of the first electrode layer 421 may be further improved.

The second electrode layer 442 may be formed over the first electrode layer 421. In one example, the second electrode layer 422 may come into contact with the first electrode layer 421, which may simplify the structure of the first electrode 42. However, the present inventive concept is not limited thereto, and various other alterations or modifications are possible and usable. For example, an alteration in which a separate layer may be present between the first electrode layer 421 and the second electrode layer 422 is possible.

The second electrode layer 422, disposed over the first electrode layer 421, may be formed of a material having electrical conductivity superior to that of the first electrode layer 421. As such, the efficiency by which the second electrode layer 422 collects carriers and a reduction in the resistance of the second electrode layer 422 may be further improved. In one example, the second electrode layer 422 may be formed of a metal, which is opaque or has lower transparency than the first electrode layer 421 and has electrical conductivity superior to that of the first electrode layer 421.

As described above, because the second electrode layer 422 is opaque or has low transparency, and thus may prevent the entry of light, the second electrode layer 422 may have a given pattern so as to minimize shading loss. The second electrode layer 422 has a smaller area than the first electrode layer 421. Thereby, light may be introduced into a portion at which the second electrode layer 422 is not formed. The first and second electrode layers 421 and 422 of the first electrode 42 may be formed via various methods. In one example, the first and second electrode layers 421 and 422 may be formed via deposition, sputtering, printing or the like.

In the same manner as the first electrode 42, the second electrode 44 includes the first and second electrode layers 441 and 442 thereon. The first and second electrode layers 441 and 442 included in the second electrode 44 may be substantially the same as the first and second electrode layers 421 and 422 included in the first electrode 42. Thus, a repeated or redundant description may be omitted.

The above described features, configurations, effects, and the like are included in at least one of the embodiments of the present inventive concept, and should not be limited to only one embodiment. In addition, the features, configurations, effects, and the like as illustrated in each embodiment may be implemented with regard to other embodiments as they are combined with one another or modified by those skilled in the art. Thus, content related to these combinations and modifications should be construed as including in the scope and spirit of the inventive concept as disclosed in the accompanying claims.

## Claims

1. A solar cell comprising:
a semiconductor substrate including a semiconductor material;
a tunneling layer disposed over one surface of the semiconductor substrate;
a first conductive area and a second conductive area disposed over the tunneling layer and having opposite conductive types; and
an electrode including a first electrode electrically connected to the first conductive area and a second electrode electrically connected to the second conductive area,
wherein at least one of the first conductive area and the second conductive area is configured as a metal compound layer.

2. The solar cell according to claim 1, wherein at least one of the first conductive area and the second conductive area is configured as a metal oxide layer.

3. The solar cell according to claim 1 or 2, wherein the semiconductor substrate includes silicon as the semiconductor material, a conductive type of which is an n-type.

4. The solar cell according to claim 3, wherein the first conductive area satisfies at least one of the following:
it is configured as a metal compound layer;
it has a lower Fermi level than a Fermi level of the semiconductor substrate; and
it has a greater work function than a work function of the semiconductor substrate; and
it configured as a molybdenum oxide layer, a tungsten oxide layer, or a vanadium oxide layer.

5. The solar cell according to claim 3 or 4, wherein the second conductive area satisfies at least one of the following:
it is configured as a metal compound layer;
it has a higher Fermi level than a Fermi level of the semiconductor substrate;
it has a smaller work function than a work function of the semiconductor substrate; and
it is configured as a titanium oxide layer or a zinc oxide layer.

6. The solar cell according to any one preceding claim, wherein the electrode connected to at least one of the first conductive area and the second conductive area includes a first electrode layer including a transparent conductive material and a second electrode layer formed over the first electrode layer, and having a pattern.

7. The solar cell according to any one preceding claim, further comprising a front-surface field-forming layer disposed over another surface opposite the one surface of the semiconductor substrate and configured as a layer including a fixed charge or including a metal compound.

8. The solar cell according to claim 7, wherein the front-surface field-forming layer includes at least one of an aluminum oxide layer, a molybdenum oxide layer, a tungsten oxide layer, a vanadium oxide layer, a titanium oxide layer, and a zinc oxide layer.

9. The solar cell according to claim 7 or 8, wherein the layer including the metal compound, which configures the front-surface field-forming layer, and the metal compound layer, which is included in at least one of the first conductive area and the second conductive area, are formed of the same material.

10. A solar cell comprising:
a semiconductor substrate;
a first conductive area formed on one surface of the semiconductor substrate;
a second conductive area formed on another surface opposite the one surface of the semiconductor substrate;
a first electrode connected to the first conductive area; and
a second electrode connected to the second conductive area,
wherein each of the first conductive area and the second conductive area is configured as a metal oxide layer.

11. The solar cell according to claim 10, wherein the first conductive area and the second conductive area include respectively different metal oxide layers.

12. The solar cell according to claim 10 or 11, wherein the metal oxide layer is formed of a binary compound.

13. The solar cell according to any one of claims 10 to 12, wherein the semiconductor substrate includes silicon as a semiconductor material, a conductive type of which is an n-type.

14. The solar cell according to claim 13, wherein the first conductive area satisfies at least one of the followings:
it has a greater work function than a work function of the semiconductor substrate; and
it is configured as a molybdenum oxide layer, a tungsten oxide layer, a vanadium oxide layer, a titanium oxide layer, a nickel oxide layer, a copper oxide layer, a rhenium oxide layer, a tantalum oxide layer, or a hafnium oxide layer.

15. The solar cell according to claim 13 or 14, wherein the second conductive area satisfies at least one of the followings:
it has smaller work function than a work function of the semiconductor substrate; and
it is configured as a titanium oxide layer, a zinc oxide layer, a tin oxide layer, or a zirconium oxide layer.
